Europäisches Patentamt

(19) European Patent Office

Office européen des brevets

(11) Publication number: **0 135 395**
**B1**

(12) EUROPEAN PATENT SPECIFICATION

(45) Date of publication of patent specification: **25.11.87**

(51) Int. Cl.⁴: **H 01 L 27/02**

(21) Application number: **84306328.0**

(22) Date of filing: **17.09.84**

(54) **MIS IC protected from static charge breakdown.**

(30) Priority: **17.09.83 JP 171684/83**

(43) Date of publication of application:
**27.03.85 Bulletin 85/13**

(45) Publication of the grant of the patent:
**25.11.87 Bulletin 87/48**

(84) Designated Contracting States:
**DE FR GB**

(56) References cited:
**DE-A-3 238 486**
**US-A-4 039 869**

(73) Proprietor: **FUJITSU LIMITED**
**1015, Kamikodanaka Nakahara-ku**
**Kawasaki-shi Kanagawa 211 (JP)**

(72) Inventor: **Koshizuka, Atuo c/o Fujitsu Limited**
**Patent Department 1015 Kamikodanaka**
**Nakahara-ku Kawasaki-shi Kanagawa, 211 (JP)**

(74) Representative: **Sunderland, James Harry et al**
**HASELTINE LAKE & CO Hazlitt House**
**28 Southampton Buildings Chancery Lane**
**London WC2A 1AT (GB)**

Courier Press, Leamington Spa, England.

**Description**

The present invention relates to a metal insulator semiconductor (MIS) type integrated circuit (IC) which is protected from damage caused by static charge.

A problem which can occur during handling of ICs is static charge breakdown, due to which an IC which has passed testing is found not to work properly when it is mounted on a printed circuit board. Static charge breakdown occurs when static charge is conducted to the IC during handling, causing a surge of static charge in the IC. The incidence of static charge breakdown is particularly high for MIS type ICs (MIS ICs) for which it is to some extent an inherent problem. This is because, in MIS ICs an upper layer of the IC is highly insulated from its surroundings by an insulating film, and has a fine gate structure which is very fragile.

Attempts have been made to increase the ability of ICs to withstand static charge. Surge protection has been devised for an input terminal or input electrode of input transistors of the IC, and this is effective to some extent in decreasing the damage cause by surges of static charge. But the protection given is still inadequate, and occasionally ICs provided with protection circuits are found to be damaged by surges.

According to the present invention, there is provided a MIS IC (Metal Insulator Semiconductor type Integrated Circuit) including:

first and second voltage supply lines, one of said voltage supply lines being a positive side voltage supply line and the other being a negative side voltage supply line;

inner circuitry;

input circuit connected between said first and second voltage supply lines comprising an input MIS transistor the gate of which is connected to an input pad of the IC, and

a protection MIS transistor, connected between the input circuitry and the second voltage supply line, characterised in that

the gate of the protection MIS transistor is connected to the first voltage supply line, the protection MIS transistor being a p-channel transistor in a case in which the first voltage supply line is the negative side voltage supply line, or an n-channel transistor in a case in which the first voltage supply line is the positive side voltage supply line.

The inventor of the present invention has established that damage to previous surge protected ICs occurs almost always in an input circuit of the IC which is located at the periphery of the chip, and that damage hardly ever occurs in inner logic circuits, which constitute the main part of the IC. From further investigation the inventor has discovered that the damage is concentrated in a MIS transistor of an input circuit whose source or drain is connected to a voltage source line.

An embodiment of the present invention can provide a protection circuit in a MIS IC, for protection against static charge breakdown. More pre-cisely, an embodiment of the present invention can improve the ability of an IC to resist static charge breakdown, by providing a circuit to protect an input circuit in the IC.

An embodiment of the present invention can provide a protection circuit placed between a voltage source line and an input circuit of a MIS IC which increases the ability of the IC to resist static charge breakdown.

An embodiment of the present invention can also decrease the incidence of failure of MIS ICs caused by static charge breakdown.

The inventor supposes that for protection against static charge breakdown, it is inadequate merely to protect an input terminal side, as breakdown is caused not only from an input terminal side but also from surges induced in a voltage supply line.

With this consideration, according to the present invention static charge protection is attained by providing a protection MIS transistor between an input circuit and a voltage supply line of the input circuit.

Reference is made, by way of example, to the accompanying drawings in which:

Fig. 1 is a circuit diagram of a MIS inverter used for an input circuit of a prior art IC circuit;

Fig. 2 shows schematically the structure of a portion of an IC die corresponding to the circuit of Fig. 1;

Fig. 3 is a circuit diagram of an input circuit protected from static charge breakdown embodying the present invention;

Fig. 4 shows schematically the structure of a portion of an IC die corresponding to Fig. 3; and

Fig. 5 is a circuit diagram for another embodiment of the present invention.

Throughout the drawings like reference numerals or characters designate like or similar parts.

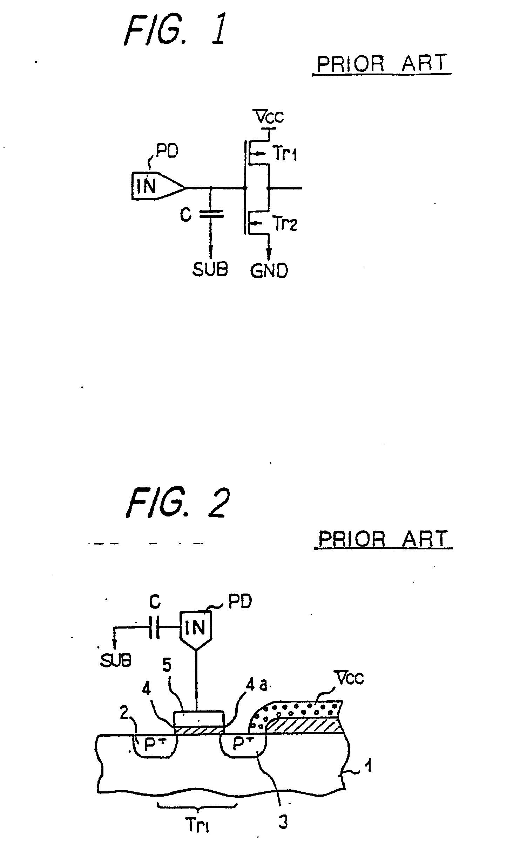

Fig. 1 shows an example of a C—MIS (Complementary Metal Insulator Semiconductor) type inverter for an input circuit of a prior art MIS IC. The circuit comprises series connected p-channel and n-channel MIS transistors $Tr_1$ and $Tr_2$. Commonly connected gates of these transistors are connected to an input pad PD, to which an input signal is applied. Sources of the transistors $Tr_1$ and $Tr_2$ are respectively connected to $V_{CC}$ and $V_{SS}$ (GND) lines, for supply from the positive and negative (or ground) sides of a power supply source, respectively.

Static charge breakdown may occur when an input terminal (a pin of the IC package) is contacted by a finger instrument. Therefore, as mentioned, static charge protection has so far been concentrated upon the input terminal side of the IC. Many protection circuits are known (for example as disclosed in U.S. Patent Application No., 556,097, Nov. 29, 1983 by Yoshihiro Takemae). Commonly, a diode is implemented in the place marked C in Fig. 1 to absorb surge voltages.

Most known protection circuits are effective to some extent in reducing incidence of failure caused by static charge breakdown. But failure occurs even in devices provided with surge protection circuits. The inventor has determined that failures of ICs provided with protection circuits occur in I/O (Input/Output) circuits of the ICs which are usually located on the peripheries of the Ic dies for processing I/O signals. Moreover, such failures are concentrated almost one hundred percent in input circuits of the I/O circuits. This may be understood by the fact that an input circuit if an I/O circuit is more fragile than an output circuit of an I/O circuit, which is composed from larger transistors than those in the input circuit.

The inventor discovered that failure does not occur in inner circuits located in the centre part of an IC die, which comprises a plurality of fine MIS transistors and which perform the main part of the IC logic. The reason why these inner circuits do not suffer from static charge breakdown will be discussed later. Further investigation indicated that failure often occurs in the gate of a transistor, e.g. $Tr_1$ in Fig. 1, which is connected to a power supply line $V_{cc}$ in an I/O circuit.

Fig. 2 shows schematically a cross-sectional view of an IC die, illustrating the structure of a portion relevant to failure of the circuit of Fig. 1. In the Figure, 1 is an n-type semiconductor substrate, 2 and 3 are source and drain regions of the p-channel MIS transistor $Tr_1$, 4 is a gate insulation film and 5 is a gate electrode. The voltage supply line $V_{cc}$ is usually constituted by an aluminium wiring layer, which (in this example) is connected to the $p^+$ region 3.

Precise observation indicated that in an input circuit having a construction as shown in part by Fig. 2, breakdown failure is caused by damage to the gate oxide layer 4 of $Tr_1$; in particular, the damage occurs in the region marked 4a in the Figure, that is the side of the gate which is adjacent to the $V_{cc}$ line.

The inventor believes that the mechanism of such failure is as follows. If an IC package is contacted by a finger or instrument when under a floating condition, that is when the IC is not connected to a circuit (not mounted on a printed circuit board), there is a chance that a surge of static charge will occur. If the surge occurs in an input terminal (pin) of the package, the IC may be protected by a surge protection circuit as previously proposed, if one is provided, but if the surge occurs in the $V_{cc}$ line (via a voltage source pin), the IC has no protection.

Consider the case of Fig. 1, for example. When an IC package containing this circuit is in a floating condition, the transistors $Tr_1$ and $Tr_2$ are not working, (i.e. they are OFF) because their electrodes are not supplied with the required voltage. Therefore they act merely as a resistance between $V_{cc}$ and $V_{ss}$. If a surge occurs in the $V_{cc}$ line the electrode 3 of $Tr_1$, which is connected to $V_{cc}$, will reach a high voltage relative to $V_{ss}$ (ground). Voltage build up at the gate electrodes of $Tr_1$ and $Tr_2$ is very slow compared to that of $V_{cc}$, since the gates have a large capacitance C with respect to the substrate SUB or ground GND, because the gates are connected to the input pad PD and to a surge protection circuit (not shown) which usually comprises a diode having a large capacitance with respect to ground.

Therefore, at an instant when a surge occurs (in the $V_{cc}$ line), the voltage between the electrode 3 (for example the source electrode of $Tr_1$) and the gate electrode 5 is highest, so static breakdown occurs at the point 4a in Fig. 2. Once static breakdown has occurred, a surge current runs through the point 4a to the gate electrode 5 and input pad PD, and the pad is charged up to a high voltage. Owing to the large capacitance C or surge protection circuit provided in the input side, the ground of the IC package is then charged up, and the surge is over. This process can occur with a surge voltage of either polarity.

The above explanation has been made with respect to the example of part of an input circuit shown in Fig. 1, but it will be understood that the situation for other types of input circuit is similar. In other types of input circuit also, the gate of a MIS transistor in a region adjacent to a $V_{cc}$ line, is where static charge breakdown occurs.

With respect ot the inner circuitry of a MIS IC which is composed of a plurality of C—MIS circuits similar to that of Fig. 1, a gate wiring line of each C—MIS circuit is very thin and short compared to that of an input circuit. Moreover, the inner C—MIS circuits do not include an input pad PD, so their gate capacitance against ground is very small compared to that of an input circuit. Accordingly, when a surge voltage appears in the $V_{cc}$ line, gate voltages in the inner circuitry vary in close correspondence to the variation of $V_{cc}$, so breakdown does not occur, and the inner circuitry is not damaged by static charge breakdown.

The observation that an input circuit suffers static charge breakdown, but inner circuitry does not, may also be explained as follows. In the transient state during a surge of static charge, an inner C—MIS circuit may be considered as a mere resistance and (very small) capacitance connected between $V_{cc}$ and $V_{ss}$ or GND. So, as mentioned before, $V_{cc}$ and GND are charged up rapidly and their potentials follow the voltage of $V_{cc}$. Hence the inner circuitry does not suffer static charge breakdown. By contrast, the gate circuit in an input circuit (for example, the circuit of the gates of $Tr_1$ and $Tr_2$ in Fig. 1) is isolated from the GND or $V_{ss}$ line, and has a large capacitance. So, the change of potential of the gates is delayed with respect to the variation of potential of the $V_{cc}$ or GND line.

From these considerations, it was decided to provide a protection circuit for an input circuit of a MIS IC in order to protect it perfectly from static charge breakdown. For such a protection circuit, it is not possible to provide a diode as for an input electrode to absorb the surge current, as such a diode would short the source voltage. The requirements for the static charge protection circuit are firstly, to absorb surges of static charge whenever the electrodes are not supplied with a proper operating voltage. and secondly, when a proper (operating voltage is applied to the circuit, to have no detrimental effect upon the operation of the main circuitry. The present invention provides a protection circuit which fulfils these requirements.

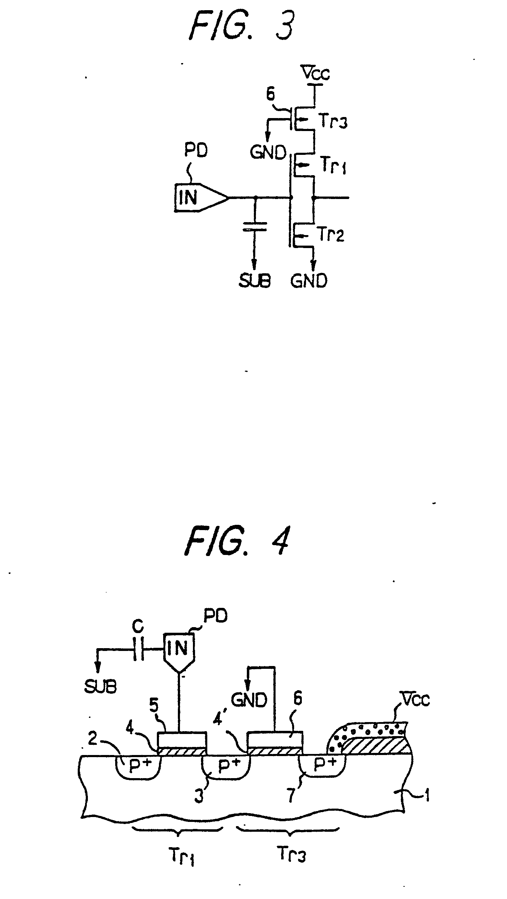

Fig. 3 shows a circuit diagram for part of an input circuit for a MIS IC protected from static charge breakdown by a protection circuit, as a first embodiment of the present invention. In comparison with the circuit of Fig. 1, the circuit of Fig. 3 additionally comprises a protection transistor $Tr_3$, inserted between a transistor of the input circuit ($Tr_1$) and the voltage source line $V_{cc}$. In this embodiment, the protection transistor $Tr_3$ is a p-channel MIS transistor and gate of $Tr_3$ is connected to $V_{ss}$ (GND), the negative side source line or ground line. Fig. 4 shows a cross sectional view of the circuit of Fig. 3. Like reference numerals designate parts corresponding to those in Fig. 2. In the Figure, 4' is a gate insulation film of the protection transistor $Tr_3$, and 7 is its drain or source constituted by a $p^+$ type region.

The operation and effect of the protection circuit is as follows. When the IC is loaded on a printed circuit board and supplied with a proper voltage, the protection transistor $Tr_3$ is conductive, so that transistor $Tr_1$ of the input circuit is supplied with the source voltage $V_{cc}$, as the voltage drop across $Tr_3$ is negligibly small. Therefore, the input circuit operates as normal.

When the Ic is floating, that is the IC is not connected to an external circuit, and if a static surge appears on the $V_{cc}$ line, due to contact with the voltage source pin of the IC package by a human finger, for example, the potential on the $V_{cc}$ line goes up very rapidly. At the same time the potential of the ground line GND also goes up, because GND is in a floating condition and is hence charged up through the main logic circuit of the IC (not shown), which can be considered at this time to act as a resistance and capacitance between $V_{cc}$ and $V_{ss}$ or GND. (Therefore, when $V_{cc}$ and GND are in a floating state, their potentials vary almost identically with variation of $V_{cc}$. This explains again the fact that main logic circuitry (inner circuitry) does not suffer from static charge breakdown).

At this time, therefore, the transistor $Tr_3$ is cut off or nearly cut off, and the input circuit (in particular, the inverter $Tr_1$ and $Tr_2$) is protected. It will be clear that the protection effect does not depend on the polarity of the surge voltage.

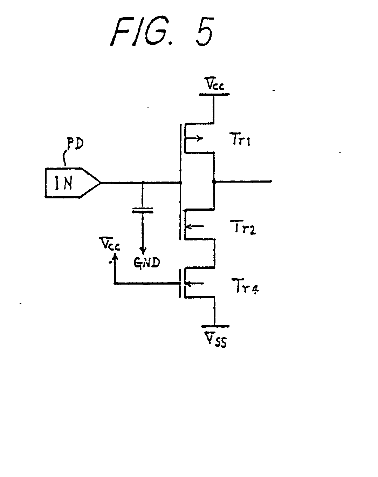

Fig. 5 shows an input circuit provided with another protection circuit, as a second embodiment of the present invention, using an n-channel MIS transistor. In comparison with Fig. 3, the p-channel MIS transistor $Tr_3$ is replaced by an n-channel MIS transistor $Tr_4$. This is inserted between the negative side voltage source line $V_{ss}$ (or ground line GND) and the input circuit transistor $Tr_2$, as the protection transistor. The gate of the protection transistor $Tr_4$ is connected to $V_{cc}$. The construction of the device will be easily understood by analogy with the above explanation regarding Fig. 4. Therefore, it will not described herein for the sake of simplicity.

In the circuit of Fig. 5, when a normal (operating voltage is supplied, the protection transistor $Tr_4$ is in a conductive state, so the input circuit inverter ($Tr_1$ and $Tr_2$) works normally. On the other hand, when the IC is floating and a surge voltage appears on the $V_{cc}$ line, the potential of the $V_{ss}$ line or GND line follows that of the $V_{cc}$ line, so the transistor $Tr_4$ is cut off, and the input circuit is protected. Again, the protection effect does not depend on the polarity of the surge potential.

The design of the protection transistor $Tr_3$ or $Tr_4$ is not critical. It is not necessary to make $Tr_3$ or $Tr_4$ especially large, because the current which $Tr_1$ or $Tr_2$ must supply is relatively small, since the input circuit does not consume much current. In practice, there are many types of transistor pattern in a typical MIS IC especially in LSI (Large Scale Integration) devices, so any one MIS transistor pattern can be used for the protection transistor, which can be fabricated at the same time as the transistors of that pattern. For example, the pattern used may be the same as that of the input circuit transistors $Tr_1$ or $Tr_2$. Therefore, it will be clear that fabricaton of a protection circuit in accordance with the present invention does not require additional processing steps for a typical IC.

Some modifications to the protection circuits described above may occur to those skilled in the art. For example, both p-channel and n-channel MIS transistors may be provided in respect of the same input circuit, for example in the respective positions of $Tr_3$ and $Tr_4$ in Figs. 3 and 5. Such modifications are all within the scope of the present invention.

It is difficult to verify the actual operation mechanism of the protection circuit, since static charge surges are transient phenomena of very short duration. Therefore, the explanation given above concerning the operation of the protection circuit should be regarded only as a tentative explanation. Nevertheless, IC circuits provided with static charge protection circuits in accordance with the present invention show excellent resistance to static charge breakdown.

The following test was performed on ICs which were not connected to an external circuit. A charge pulse was applied to the $V_{cc}$ pin of an IC package from a condenser of 100 pF charged up to a predetermined voltage, to simulate a surge of static charge. The IC was then tested to see if static charge breakdown had occurred. These steps were repeated, increasing the voltage of the condenser, until breakdown of the IC had occurred. Prior art ICs were found to break down at below 500 volts. However, ICs provided with a protection circuit in accordance with the present invention were found to withstand more than 1,500 volts.

As has been described above, a protection circuit in accordance with the present invention is very effective for protecting a MIS IC from damage by static charge breakdown.

## Claims

1. A MIS IC (Metal Insulator Semiconductor type Integrated Circuit) including:
first and second voltage supply lines ($V_{cc}$, $V_{ss}$), one of said voltage supply lines being a positive side voltage supply line ($V_{cc}$) and the other being a negative side voltage supply line ($V_{ss}$);
inner circuitry;
input circuitry ($Tr_1$, $Tr_2$) connected between said first and second voltage supply lines ($V_{cc}$, $V_{ss}$) comprising an input MIS transistor ($Tr_1$, $Tr_2$) the gate of which is connected to an input pad (PD) of the IC, and
a protection MIS transistor ($Tr_3$ or $Tr_4$), connected between the input circuitry ($Tr_1$, $Tr_2$) and the second voltage supply line ($V_{cc}$ or $V_{ss}$), characterised in that
the gate (6) of the protection MIS transistor ($Tr_3$ or $Tr_4$) is connected to the first voltage supply line ($V_{ss}$ or $V_{cc}$), the protection MIS transistor ($Tr_3$ or $Tr_4$) being a p-channel transistor ($Tr_3$) in a case in which the first voltage supply line is the negative side voltage supply line ($V_{ss}$), or an n-channel transistor ($Tr_4$) in a case in which the first voltage supply line is the positive side voltage supply line $V_{cc}$.

2. A MIS IC (Metal Insulator Semiconductor type Integrated Circuit) including:
first and second voltage supply lines ($V_{cc}$, $V_{ss}$), one of said voltage supply lines being a positive side voltage supply line ($V_{cc}$) and the other being a negative side voltage supply line ($V_{ss}$);
inner circuitry;
input circuitry ($Tr_1$, $Tr_2$) comprising
first and second MIS transistors ($Tr_1$, $Tr_2$) connected in series, the first voltage supply line ($V_{ss}$ or $V_{cc}$) being connected to the first input MIS transistor ($Tr_2$ or $Tr_1$); and
a protection MIS transistor ($Tr_3$ or $Tr_4$) connected between the second input MIS transistor ($Tr_1$ or $Tr_2$) and the second voltage supply line ($V_{cc}$ or $V_{ss}$), characterised in that
the first and second MIS transistors are input MIS transistors and have their gates connected in common to an input pad (PD) of the Ic, and in that
the gate of the protection MIS transistor ($Tr_3$ or $Tr_4$) is connected to the first voltage supply line ($V_{ss}$ or $V_{cc}$), the protection MIS transistor ($Tr_3$ or $Tr_4$) being a p-channel transistor ($Tr_3$) in a case in which the first voltage supply line is the negative side voltage supply line ($V_{ss}$), or an n-channel transistor ($Tr_4$) in a case in which the first voltage supply line is the positive side voltage supply line ($V_{ss}$).

3. A MIS IC according to claim 2, wherein the first voltage supply line is the negative side voltage supply line ($V_{ss}$), the first input MIS transistor is an n-channel MIS transistor ($Tr_2$), and the second input MIS transistor is a p-channel MIS transistor ($Tr_1$), a drain terminal of said n-channel MIS transistor ($Tr_2$) being connected to said negative side voltage supply line ($V_{ss}$).

4. A MIS IC according to claim 2, wherein the first voltage supply line is the positive side voltage supply line ($V_{cc}$), the first input MIS transistor is a p-channel MIS transistor ($Tr_1$), and the second input MIS transistor is a n-channel MIS transistor ($Tr_2$), a source terminal of said p-channel MIS transistor ($Tr_1$) being connected to said positive side voltage suply line ($V_{cc}$).

5. A MIS IC according to any preceding claim, including a further protection MIS transistor, the gate of which is connected to the second voltage supply line ($V_{cc}$ or $V_{ss}$), connected between the input circuitry ($Tr_1$, $Tr_2$) and the first voltage supply line ($V_{ss}$ or $V_{cc}$), said further protection MIS transistor being of opposite channel type to the protection MIS transistor ($TR_3$ or $Tr_4$) of claim 1 or 2.

## Patentansprüche

1. Ein MIS—IC (Integrierte Schaltung vom Metallisolatorhalbleitertyp) mit:
ersten und zweiten Spannungsversorgungleitungen $V_{cc}$, $V_{ss}$, von denen eine eine Positivseiten-Spannungsversorgungsleitung ($V_{cc}$) und die andere eine Negativseiten-Spannungsversorgungsleitung ($V_{ss}$) ist;
einer inneren Schaltung;
einer Eingangsschaltung ($Tr_1$, $Tr_2$), die zwischen den genannten ersten und zweiten Spannungsversorgungsleitungen ($V_{cc}$, $V_{ss}$) verbunden ist und einen MIS-Transistor ($Tr_1$, $Tr_2$) umfaßt, dessen Gate mit einem Eingangspad (PD) des IC verbunden ist, und
einem Schutz-MIS-Transistor ($Tr_3$, $Tr_4$), der zwischen der Eingangsschaltung ($Tr_1$, $Tr_2$), und der zweiten Spannungsversorgungsleitung ($V_{cc}$ oder $V_{ss}$) verbunden ist, dadurch gekennzeichnet, daß
das Gate (6) des Schutz-MIS-Transistors ($Tr_3$ oder $Tr_4$) mit der ersten Spannungsversorgungsleitung ($V_{ss}$ oder $V_{cc}$) verbunden ist, der Schutz-MIS-Transistor ($Tr_3$ oder $Tr_4$) ein p-Kanal-Transistor ($Tr_3$) ist, falls die erste Spannungsversorgungsleitung eine Negativseiten-Spannungsversorgungsleitung ($V_{ss}$) ist, oder ein n-Kanal-Transistor ($Tr_4$), falls die erste Spannungsversorgungsleitung eine Positivseiten-Spannungsversorgungsleitung ($V_{cc}$) ist.

2. MIS—IC (Integrierte Schaltung vom Metallisolatorhalbleitertyp) mit:
ersten und zweiten Spannungsversorgungsleitungen $V_{cc}$, $V_{ss}$, von denen eine eine Positivseiten-Spannungsversorgungsleitung ($V_{cc}$) und die andere eine Negativseiten-Spannungsversorgungsleitung ($V_{ss}$) ist;
einer inneren Schaltung;
einer Eingangsschaltung ($Tr_1$, $Tr_2$), die
erste und zweite MIS-Transistoren ($Tr_1$, $Tr_2$), umfaßt, die in Reinhe verbunden sind, wobei die erste Spannungsversorgungsleitung ($V_{ss}$ oder $V_{cc}$) mit dem esten Eingangs-MIS-Transisor (($Tr_2$ oder $Tr_1$) verbunden ist; und
einem Schutz-MIS-Transistor ($Tr_3$ oder $Tr_4$), der zwischen dem zweiten Eingangs-MIS-Transistor ($Tr_1$ oder $Tr_2$) und der zweiten Spannungsversorgungsleitung ($V_{cc}$ oder $V_{ss}$) verbunden ist, dadurch gekennzeich- net, daß

der erste und zweige MIS-Transistor Eingangs-MIS-Transistoren sind, deren Gates gemeinsam an einem Eingangspad (PD) der IC verbunden sind, und daß

das Gate des Schutz-MIS-Transistors (Tr$_3$ oder Tr$_4$) mit der ersten Spannungsversorgungsleitung (V$_{SS}$ oder V$_{CC}$) verbunden ist, der Schutz-MIS-Transistor (TR$_3$ oder Tr$_4$) ein p-Kanal-Transistor (Tr$_3$) ist, falls die erste Spannungsversorgungsleitung eine Negativseiten-Spannungsversorgungsleitung (V$_{SS}$) ist, oder ein n-Kanal-Transistor (Tr$_4$) ist, falls die erste Versorgungsspannungsversorgungsleitung eine Positivseiten-Spannungsversorgungsleitung (V$_{CC}$) ist.

3. MIS—IC nach Anspruch 2, bei der die erste Spannungsversorgungsleitung eine Negativseiten-Spannungsversorgungsleitung (V$_{SS}$) ist, der erste Eingangs-MIS-Transistor ein n-Kanal-MIS-Transistor (Tr$_2$) ist und der zweite Eingangstransistor ein p-Kanal-MIS-Transistor (Tr$_1$) ist, und eine Drainanschluß des genannten n-Kanal-MIS-Transistors (Tr$_2$) mit der genannten Negativseiten-Spannungs- versorgungsleitung (V$_{SS}$) verbunden ist.

4. MIS—IC nach Anspruch 2, bei der die erste Spannungsversorgungsleitung eine Positivseiten-Spannungsversorgungsleitung (V$_{CC}$) ist, der erste Eingangs-MIS-Transistor ein p-Kanal-MIS-Transistor (Tr$_1$) ist, und der zweite Eingangs-MIS-Transistor ein n-Kanal-MIS-Transistor (Tr$_2$) ist, ein Sourceanschluß des genannten p-Kanal-MIS-Transistors (TR$_1$) mit der genannten Positivseiten-Spannungsversorgungsleitung (V$_{CC}$) verbunden ist.

5. MIS—IC nach einem der vorhergehenden Ansprüche, ferner mit einem Schutz-MIS-Transistor, dessen Gate mit der zweiten Spannungsversorgungsleitung (V$_{CC}$ oder V$_{SS}$) verbunden ist, der zwischen der Eingangs- schaltung (Tr$_1$, Tr$_2$) und der ersten Spannungsver- sorgungsleitung (V$_{SS}$ oder V$_{CC}$) verbunden ist, wobei der genannte weiter Schutz-MIS-Transistor vom entge- gengesetzten Kanaltyp zu dem Schutz-MIS-Transistor (Tr$_3$ oder Tr$_4$) von Anspruch 1 oder 2 ist.

**Revendications**

1. Circuit intégré du type MIS (métal-isolant-semiconducteur) comportant:
    une première et une deuxième ligne d'alimentation en tension (V$_{CC}$, V$_{SS}$), l'une desdites lignes d'alimentation en tension étant une ligne d'alimentation en tension du côté positif (V$_{CC}$) et l'autre étant une ligne d'alimentation en tension du côté négatif (V$_{SS}$);
    une circuit interne;
    un circuit d'entrée (Tr$_1$, Tr$_2$) connecté entre lesdites première et deuxième lignes d'alimentation en tension (V$_{CC}$, V$_{SS}$) comprenant un transistor d'entrée MIS (Tr$_1$, Tr$_2$) dont la grille est connectée à un plot d'entrée (PD) du circuit intégré; et
    un transistor MIS de protection (Tr$_3$ ou Tr$_4$), connecté entre le circuit d'entrée (Tr$_1$, Tr$_2$) et la deuxième ligne d'alimentation en tension (V$_{CC}$ ou

V$_{SS}$); caractérisé en ce que la grille (6) du transistor MIS de protection (Tr$_3$ ou Tr$_4$) est connectée à la première ligne d'alimentation en tension (V$_{SS}$ ou V$_{CC}$), le transistor MIS de protection (Tr$_3$ ou Tr$_4$) étant un transistor à canal p (Tr$_3$) dans le cas où la première ligne d'alimentation en tension est une ligne d'alimentation en tension du côté négatif (V$_{SS}$), ou un transistor à canal n (Tr$_4$) dans le cas où la première ligne d'alimentation en tension est une ligne d'alimentation en tension du côté positif (V$_{CC}$).

2. Circuit intégré du type MIS (métal-isolant-semiconducteur) comportant:
    une première et une deuxième ligne d'alimentation en tension (V$_{CC}$, V$_{SS}$), une desdites lignes d'alimentation en tension étant une ligne d'alimentation en tension du côté positif (V$_{CC}$) et l'autre étant une ligne d'alimentation en tension du côté négatif (V$_{SS}$);
    une circuit interne;
    un circuit d'entrée (Tr$_1$, Tr$_2$) comprenant un premier et un deuxième transistor MIS (Tr$_1$, Tr$_2$) connectés en série, la première ligne d'alimentation en tension (V$_{SS}$ ou V$_{CC}$) étant connectée au premier transistor MIS d'entrée (Tr$_2$ ou Tr$_1$); et
    un transistor MIS de protection (Tr$_3$ ou Tr$_4$) connecté entre le deuxième transistor MIS d'entrée (Tr$_1$ ou Tr$_2$) et la deuxième ligne d'alimentation en tension (V$_{CC}$ ou V$_{SS}$), caractérisé en ce que les premier et deuxième transistors MIS sont des transistors MIS d'entrée et ont leurs grilles connectées en commun à un plot d'entrée (PD) du circuit intégré, et en ce que la grille du transistor MIS de protection (Tr$_3$ ou Tr$_4$) est connectée à la première ligne d'alimentation en tension (V$_{SS}$ ou V$_{CC}$), le transistor MIS de protection (Tr$_3$ ou Tr$_4$) étant un transistor à canal p (Tr$_3$) dans le cas où la première ligne d'alimentation en tension est une ligne d'alimentation en tension du côté négatif (V$_{SS}$), ou bien un transistor à canal n (Tr$_4$) dans le cas où la première ligne d'alimentation en tension est une ligne d'alimentation en tension du côté positif (V$_{CC}$).

3. Circuit intégré du type MIS selon la revendication 2, où la première ligne d'alimentation en tension est un ligne d'alimentation en tension du côté négatif (V$_{SS}$), le premier transistor MIS d'entrée est un transistor MIS à canal n (Tr$_2$) et le deuxième transistor MIS d'entrée est un transistor MIS à canal p (Tr$_1$), une borne de drain dudit transistor MIS à canal n (Tr$_2$) étant connectée à ladite ligne d'alimentation en tension du côté négatif (V$_{SS}$).

4. Circuit intégré du type MIS selon la revendication 2, où la première ligne d'alimentation en tension est un ligne d'alimentation en tension du côté positif (V$_{CC}$), le premier transistor d'entrée MIS est un transistor MIS à canal p (Tr$_1$), et la deuxième transistor MIS d'entrée est un transistor MIS à canal n (Tr$_2$), une borne de source dudit transistor MIS à canal p (Tr$_1$) étant connectée à ladite ligne d'alimentation en tension du côté positif (V$_{CC}$).

5. Circuit intégré du type MIS selon l'une quelconque des revendications précédentes, comportant un transistor MIS de protection supplémentaire, dont la grille est connectée à la deuxième ligne d'alimentation en tension ($V_{cc}$ ou $V_{ss}$), connecté entre le circuit d'entrée ($Tr_1$, $Tr_2$) et la première ligne d'alimentation en tension ($V_{ss}$ ou $V_{cc}$), ledit transistor MIS de protection supplémentaire étant d'un type de canal opposé au transistor MIS de protection ($Tr_3$ ou $Tr_4$) de la revendication 1 ou 2.

## FIG. 1

PRIOR ART

## FIG. 2

PRIOR ART

## FIG. 3

## FIG. 4

# FIG. 5